# EUROPEAN PATENT SPECIFICATION

(11) **EP 3 024 307 B1**
(45) Date of publication and mention of the grant of the patent: **03.01.2018**
(21) Application number: 15194159.8
(22) Date of filing: 11.11.2015
(51) Int. Cl.: H05K 1/02, H05K 7/14, H02J 4/00

(54) **POWER CONTROL ASSEMBLY WITH VERTICALLY MOUNTED POWER DEVICES**
LEISTUNGSREGELUNGSANORDNUNG MIT VERTIKAL MONTIERTEN LEISTUNGSVORRICHTUNGEN
ENSEMBLE DE COMMANDE DE PUISSANCE AVEC DES DISPOSITIFS D'ALIMENTATION MONTÉS VERTICALEMENT

(30) Priority: 20.11.2014 US 201414548637
(43) Date of publication of application: 25.05.2016
(73) Proprietor: Hamilton Sundstrand Corporation, Charlotte, NC 28217 (US)
(72) Inventor: DICKEY, John A., Caledonia, Illinois 61011 (US); COONEY, Robert C., Janesville, Wisconsin 53546 (US); HANSON, Michael J., Rockford, Illinois 61114 (US); KILROY, Donald G., Rockford, Illinois 61108 (US); MILLER, Christian, Beloit, Wisconsin 53511 (US)
(74) Representative: Iceton, Greg James

(56) References cited:
- EP-A2- 2 355 638
- JP-A- 2013 027 286
- US-A1- 2003 137 813

## Description

### BACKGROUND

The present invention relates generally to power control devices, and in particular to vertically mounted power control devices.

Power control devices, such as solid state power controllers (SSPCs) on aircraft, are traditionally mounted on circuit boards that are configured to lay horizontally, or utilize unpackaged circuit die bonded directly to the circuit board. These devices are often thin compared to their respective lengths and widths and in turn utilize a large area of the circuit board without much height. To gain circuit board area, the size of the board may be increased, or more boards may be utilized with less spacing between each board. There is a limit to how close the boards may be placed due to, for example, the height of connectors. This often results in a substantial amount of wasted volume. It is desirable to increase the efficiency of the mounted power control devices by utilizing this wasted volume.

US 2003/0137813 relates to a circuit-constituting unit forming a distribution circuit. JP 2013027286 relates to a switching module, a circuit structure and an electric connection box.

### SUMMARY

A power control system includes a circuit board, a bus bar, and a distribution bar. The bus bar is connected to the circuit board and configured to receive input power from an external power source. The distribution bar is connected to receive the input power from the bus bar. The distribution bar includes a first section connectable to the bus bar to receive the input power, a second section configured to carry the input power from the first section, a third section connectable to the circuit board, and a power switch connected to the second section and configured to selectively distribute the input power as output power to at least one load. The first section and the third section extend away from the second section.

### BRIEF DESCRIPTION OF THE DRAWINGS

FIG. 1 is a diagram illustrating a power control system utilizing L-shaped bars for improved circuit density.
FIGS. 2A and 2B are perspective views of an L-shaped bar utilized in a power control system.

### DETAILED DESCRIPTION

A power control system is disclosed herein that includes vertically mounted power control devices for electrical power distribution. The power control system includes a circuit board, distribution bars, a bus bar, a controller, and input/output connectors. Each distribution bar includes three sections. The first section is attached to receive power from the bus bar. At least one power switch is mounted to the second section. The third section is attached to the circuit board. The first and third sections extend away from the second section. Each power switch mounted to the second section is configured to receive power from the bus bar through the distribution bar. Each power switch is further connected, for example, through a connector to the circuit board. In this way, power can be selectively provided from the bus bar to external loads through the power switches and the input/output connectors.

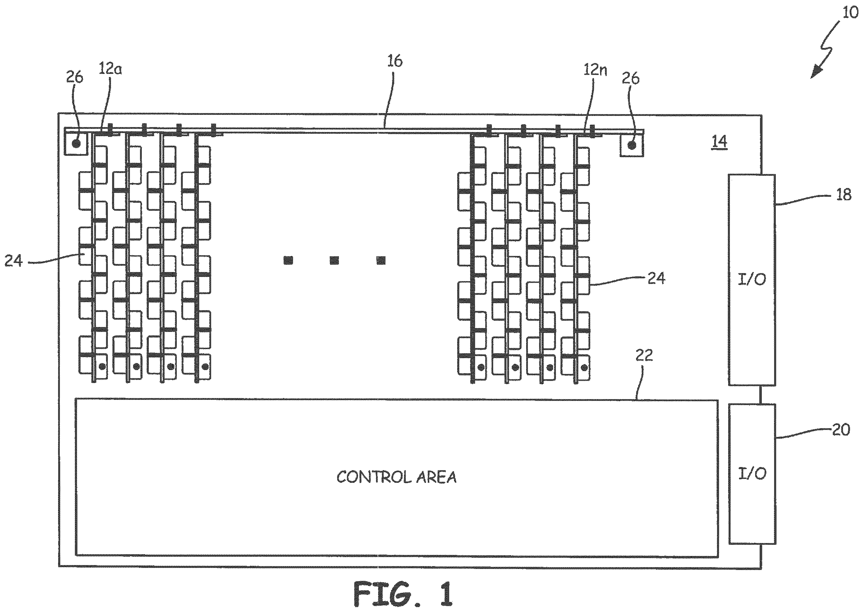

FIG. 1 is a diagram illustrating power control assembly 10 utilizing distribution bars 12a-12n for improved circuit density. Power control assembly 10 includes distribution bars 12a-12n, circuit board 14, bus bar 16, power input/output connector 18, control input/output connector 20, and control are 22. Distribution bars 12a-12n include power switches 24. Bus bar is fastened to circuit board 14 through fasteners 26, which may be bolts, rivets, spot welds, and/or any other type of fastener. Power control assembly 10 may be, for example, utilized to implement solid state power controllers to distribute power onboard aircraft. Power switches 24 may be, for example, power metal-oxide-semiconductor field-effect transistors (MOSFETs) or any other device capable of selectively providing input power as output power.

Power may be received by power control apparatus 10 from a power feed through power input/output connector 18. This power may be from any external source, such as, for example, a gas turbine generator, battery, and/or any other power source. Bus bar 16, as illustrated in FIG. 1, may receive and distribute alternating current (AC) power and/or direct current (DC) power. While illustrated as a single bus bar 16, in other embodiments, several bus bars may be implemented on circuit board 14, each configured to distribute power from a separate power input feed. For example, multiple bus bars may be configured to distribute multiple phases of AC power. In another example, a first bus bar may be configured to distribute AC power and a second bus bar may be configured to distribute DC power. Power is distributed from power input/output connector 18 through bus bar 16 to distribution bars 12a-12n. Power flows through distribution bars 12a-12n from bus bar 16 to power switches 24. Power switches 24 are each utilized to selectively distribute the power from bus bar 16 back through power input/output connector 18 to one or more loads (not shown). For AC applications, half of power switches 24 utilized to distribute power from bus bar 16 back through power input/output connector 18 to the one or more loads (not shown) may be electrically isolated from the power input due to the power switch topology used in AC applications.

Control area 22 is utilized, for example, to control the selective distribution of power through power switches 24. Control area 22 may include, for example, microcontrollers, analog circuitry, digital circuitry, and/or any other electronic components. Switches 24 may be configured, for example, in various separate channels to provide selective power to one or more separate loads. Control area 22 may also communicate with other systems, for example, onboard an aircraft through control input/output 20. The circuit board connections between power input/output connector 18 and bus bar 14, switches 24 and control area 22, and control area 22 and control input/output 20 are not illustrated in FIG. 1.

Traditionally, components in power distribution systems, such as power switches 24, have been laid down flat on circuit board 14. These devices are usually thin compared to their length and width, and as such result in using a lot of area on board 14 without much height. The usual way to gain circuit board area is make circuit board 14 larger, or to use more circuit boards within the system that are spaced closer together. There is a limit on how close the boards can be placed due to the height of some of the parts such as input/output connectors 18 and 20. This results in a substantial amount of empty volume. By mounting power switches 24 vertically on distribution bars 12a-12n, a substantial amount of this empty volume may be utilized to improve the circuit density of the system.

Distribution bars 12a-12n may be made of a thermally and electrically conductive material and may be utilized both to distribute power and act as a heat sink. Prior distribution systems may have had power components that were mounted vertically to board 16, but also included a vertically mounted heat sink with the respective component. By utilizing distribution bars 12a-12n both for electrical distribution and heat dissipation, these vertically mounted heat sinks may be eliminated. Because of this, more power switches 24 may be implemented on circuit board 14 while utilizing the same surface area of board 14, allowing for greater power density. Because the cost of components such as input/output connectors 18 and 20 may be high, overall costs of a power distribution system may be reduced by mounting a greater number of power switches 24 to each board 14, reducing the total number of boards 14 required within the system. In another embodiment, distribution bars 12a-12n may be made of material that is thermally conductive but not electrically conductive. In this case, power may be distributed from bus bar 16 to power switches 24 through, for example, circuit board traces.

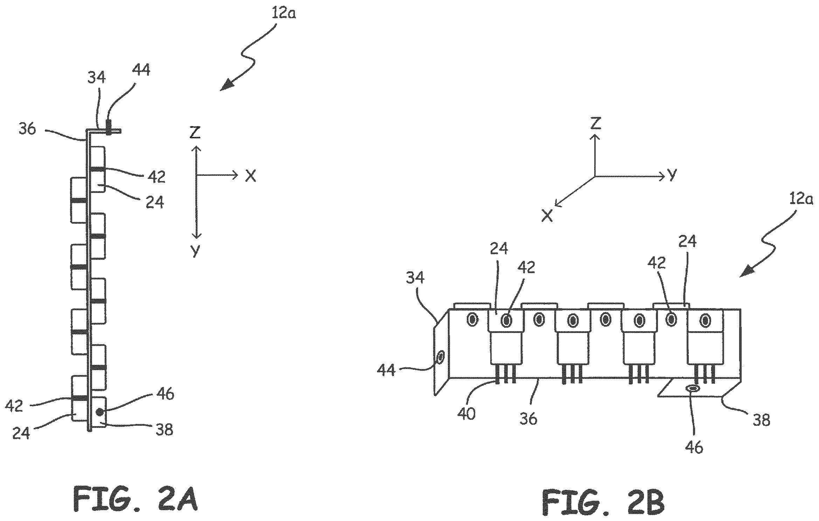

With continued reference to FIG. 1, FIGS. 2A and 2B are perspective views of power distribution bar 12a in power control assembly 10. Power distribution bar 12a may be any of power distribution bars 12a-12n of FIG. 1. Implementing each power distribution bar 12a-12n in a similar manner allows easy replacement of any power distribution bar 12a-12n. Therefore, if any power distribution bar 12a-12n fails, a separate distribution bar may be easily swapped out without great cost or effort.

Power distribution bar 12a is illustrated with respect to orthogonal X, Y, and Z axes. Power distribution bar 12a includes first section 34, second section 36, and third section 38. Power switches 24 are mounted to, for example, each side of second section 36. In an embodiment, leads of power switches 24 may be soldered to circuit board 14 to provide control to power switches 24 and carry output power from power switches 24. In another embodiment, each power switch 24 may be, for example, connected to one of connectors 40. Connectors 40 may be connected between circuit board 14 and switches 24 to provide control to respective switches 24 from controller 22, and carry output power from power switches 24. Fasteners 42 may be utilized to mount power switches 24 to second section 36, fasteners 44 may be utilized to mount first section 34 to bus bar 16 (FIG. 1), and fastener 46 may be utilized to mount third section 34 to circuit board 14 (FIG. 1). Fasteners 44 and 46 may be, for example, bolts, rivets, or any other type of removable fastener.

First section 34 extends axially along the X axis in the X-Z plane and attaches to receive power flow from bus bar 16. Second section 36 extends along the Y axis in the Y-Z plane. Third section 38 extends along the X axis, in the X-Y plane, and is fastened to circuit board 14. In this way, distribution bar 12a may be mounted such that power switches 24 are mounted in power control assembly 10 vertically, allowing for greater circuit density over previous systems. By attaching both first section 34 to bus bar 16 and third section 38 to circuit board 14, vibration of power distribution bar 12a is kept at minimal levels, which is advantageous in high vibration applications such as, for example, power systems onboard aircraft.

### Discussion of Possible Embodiments

The following are non-exclusive descriptions of possible embodiments of the present invention.

A power distribution bar includes first, second, and third sections. The first section is connectable to receive input power from a bus bar. The input power flows through the power distribution bar. At least one power switch is connected to the second section to selectively distribute power from the power distribution bar. The third section is connectable to a circuit board. The first section and the third section extend away from the second section.

The power distribution bar of the preceding paragraph can optionally include, additionally and/or alternatively, any one or more of the following features, configurations and/or additional components:
A further embodiment of the foregoing power distribution bar, wherein the first section and the third section extend along a first axis, and the second section extends along a second axis, and wherein the first and second axes are perpendicular.

A further embodiment of any of the foregoing power distribution bars, wherein the first section lies in a first plane, the second section lies in a second plane, and the third section lies in a third plane, and wherein the first, second, and third planes are orthogonal.

A further embodiment of any of the foregoing power distribution bars, wherein the at least one power switch is configured to receive a control signal from a control area connected to the circuit board.

A further embodiment of any of the foregoing power distribution bars, wherein the at least one power switch is configured to receive the control signal through a connector connected between the at least one power switch and the circuit board.

A power control system includes a circuit board, a bus bar, and a distribution bar. The bus bar is connected to the circuit board and configured to receive input power from an external power source. The distribution bar is connected to receive the input power from the bus bar. The distribution bar includes a first section connectable to the bus bar to receive the input power, a second section configured to carry the input power from the first section, a third section connectable to the circuit board, and a power switch connected to the second section and configured to selectively distribute the input power as output power to at least one load. The first section and the third section extend away from the second section.

The power control system of the preceding paragraph can optionally include, additionally and/or alternatively, any one or more of the following features, configurations and/or additional components:

A further embodiment of the foregoing power control system, wherein the first section and the third section of the first distribution bar extend along a first axis, and the second section of the first distribution bar extends along a second axis, and wherein the first and second axes are perpendicular.

A further embodiment of any of the foregoing power control systems, wherein the first section of the first distribution bar lies in a first plane, the second section of the first distribution bar lies in a second plane, and the third section of the first distribution bar lies in a third plane, and wherein the first, second, and third planes are orthogonal.

A further embodiment of any of the foregoing power control systems, further including a control area connected to the circuit board and configured to control the first power switch to selectively distribute the input power as the output power to the at least one load.

A further embodiment of any of the foregoing power control systems, further including a second power switch configured to selectively distribute the input power as the output power to the at least one load.

A further embodiment of any of the foregoing power control systems, wherein the first power switch is connected to a first side of the second section of the first distribution bar, and wherein the second power switch is connected to a second side opposite the first side of the second section of the first distribution bar.

A further embodiment of any of the foregoing power control systems, further including at least one second distribution bar connected to receive the input power from the bus bar, wherein the second distribution bar includes a first section connectable to the bus bar to receive the input power, a second section configured to carry the input power from the first section of the second distribution bar, a third section connectable to the circuit board, a first power switch connected to the second section of the at least one second distribution bar and configured to selectively distribute the input power as output power to the at least one load, and wherein the first section and the third section extend away from the second section.

A further embodiment of any of the foregoing power control systems, further including an input/output connector connected to the circuit board and configured to receive the output power from the first switch and provide the output power to the at least one load.

A further embodiment of any of the foregoing power control systems, wherein the first section of the first distribution bar is connected to the bus bar by a first fastener and the third section of the first distribution bar is connected to the circuit board by a second fastener.

A further embodiment of any of the foregoing power control systems, wherein the first power switch is connected to the second section using a third fastener, and wherein the first power switch is connected to the circuit board through a solder joint or connection.

While the invention has been described with reference to an exemplary embodiment(s), it will be understood by those skilled in the art that various changes may be made without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A power control system that includes a circuit board (14) and a bus bar (16) connected to the circuit board (14) and configured to receive input power from an external power source, the power control system **characterized by**:
a first distribution bar (12a) connected to receive the input power from the bus bar (16), wherein the first distribution bar (12a) comprises:
a first section (34) connectable to the bus bar (16) to receive the input power;
a second section (36) configured to carry the input power from the first section (34);
a third section (38) connectable to the circuit board (14);
a first power switch (24) connected to the second section (36) and configured to selectively distribute the input power as output power to at least one load;
a second power switch configured to selectively distribute the input power as the output power to the at least one load, wherein the first power switch (24) is connected to a first side of the second section (36) of the first distribution bar, and wherein the second power switch is connected to a second side opposite the first side of the second section of the first distribution bar, and wherein the second section (36) is perpendicular to the circuit board (14); and
wherein the first section (34) and the third section (38) extend away from the second section.

2. The power control system of claim 1, wherein the first section (34) and the third section (38) of the first distribution bar extend along a first axis, and the second section of the first distribution bar extends along a second axis, and wherein the first and second axes are perpendicular.

3. The power control system of claim 1 or 2, wherein the first section (34) of the first distribution bar lies in a first plane, the second section (36) of the first distribution bar lies in a second plane, and the third section (38) of the first distribution bar lies in a third plane, and wherein the first, second, and third planes are orthogonal.

4. The power control system of claim 1, 2 or 3, further comprising:
a control area connected to the circuit board (14) and configured to control the first power switch to selectively distribute the input power as the output power to the at least one load.

5. The power control system of claims 1-4, further comprising:
at least one second distribution bar connected to receive the input power from the bus bar, wherein the second distribution bar comprises:
a first section connectable to the bus bar to receive the input power;
a second section configured to carry the input power from the first section of the second distribution bar;
a third section connectable to the circuit board;
a first power switch connected to the second section of the at least one second distribution bar and configured to selectively distribute the input power as output power to the at least one load; and
wherein the first section and the third section extend away from the second section.

6. The power control system of claim 1-5, further comprising:
an input/output connector (40) connected to the circuit board (14) and configured to receive the output power from the first switch (24) and provide the output power to the at least one load.

7. The power control system of claim 1-6, wherein the first section (34) of the first distribution bar is connected to the bus bar by a first fastener and the third section (38) of the first distribution bar is connected to the circuit board by a second fastener.

8. The power control system of claim 1-7, wherein the first power switch (24) is connected to the second section (36) using a third fastener, and wherein the first power switch (24) is connected to the circuit board (14) through a solder joint or connection.

## Patentansprüche

1. Leistungssteuerungssystem, das eine Schaltungsplatine (14) und eine Sammelschiene (16) beinhaltet, die mit der Schaltungsplatine (14) verbunden und konfiguriert ist, um Eingangsleistung von einer externen Leistungsquelle zu empfangen, wobei das Leistungssteuerungssystem **gekennzeichnet ist durch**:
eine erste Verteilungsschiene (12a), die verbunden ist, um die Eingangsleistung von der Sammelschiene (16) zu empfangen, wobei die erste Verteilungsschiene (12a) umfasst:
einen ersten Abschnitt (34), der mit der Sammelschiene (16) verbindbar ist, um die Eingangsleistung zu empfangen;
einen zweiten Abschnitt (36), der konfiguriert ist, um die Eingangsleistung von dem ersten Abschnitt (34) zu übertragen;
einen dritten Abschnitt (38), der mit der Schaltungsplatine (14) verbindbar ist;
einen ersten Leistungsschalter (24), der mit dem zweiten Abschnitt (36) verbunden und konfiguriert ist, um die Eingangsleistung selektiv als Ausgangsleistung an mindestens eine Last zu verteilen;
einen zweiten Leistungsschalter, der konfiguriert ist, um die Eingangsleistung selektiv als die Ausgangsleistung an die mindestens eine Last zu verteilen, wobei der erste Leistungsschalter (24) mit einer ersten Seite des zweiten Abschnitts (36) der ersten Verteilungsschiene verbunden ist, und wobei der zweite Leistungsschalter mit einer zweiten Seite verbunden ist, die der ersten Seite des zweiten Abschnitts der ersten Verteilungsschiene gegenüberliegt, und wobei der zweite Abschnitt (36) senkrecht zu der Schaltungsplatine (14) ist; und
wobei sich der erste Abschnitt (34) und der dritte Abschnitt (38) von dem zweiten Abschnitt weg erstrecken.

2. Leistungssteuerungssystem nach Anspruch 1, wobei sich der erste Abschnitt (34) und der dritte Abschnitt (38) der ersten Verteilungsschiene entlang einer ersten Achse erstrecken, und der zweite Abschnitt der ersten Verteilungsschiene entlang einer zweiten Achse erstreckt, und wobei die erste und die zweite Achse senkrecht sind.

3. Leistungssteuerungssystem nach Anspruch 1 oder 2, wobei der erste Abschnitt (34) der ersten Verteilungsschiene in einer ersten Ebene liegt, der zweite Abschnitt (36) der ersten Verteilungsschiene in einer zweiten Ebene liegt, und der dritte Abschnitt (38) der ersten Verteilungsschiene in einer dritten Ebene liegt, und wobei die erste, zweite und dritte Ebene senkrecht sind.

4. Leistungssteuerungssystem nach Anspruch 1, 2 oder 3, weiter umfassend:
einen Steuerbereich, der mit der Schaltungsplatine (14) verbunden und konfiguriert ist, um den ersten Leistungsschalter zu steuern, um selektiv die Eingangsleistung als die Ausgangsleistung an die mindestens eine Last zu verteilen.

5. Leistungssteuerungssystem nach den Ansprüchen 1-4, weiter umfassend:
mindestens eine zweite Verteilerschiene, die verbunden ist, um die Eingangsleistung von der Sammelschiene zu empfangen, wobei die zweite
Verteilerschiene umfasst:
einen ersten Abschnitt, der mit der Sammelschiene verbindbar ist, um die Eingangsleistung zu empfangen;
einen zweiten Abschnitt, der konfiguriert ist, um die Eingangsleistung von dem ersten Abschnitt der zweiten Verteilerschiene zu übertragen;
einen dritten Abschnitt, der mit der Schaltungsplatine verbindbar ist;
einen ersten Leistungsschalter, der mit dem zweiten Abschnitt der mindestens einen zweiten Verteilungsschiene verbunden ist und konfiguriert ist, um selektiv die Eingangsleistung als Ausgangsleistung an die mindestens eine Last zu verteilen; und
wobei sich der erste Abschnitt und der dritte Abschnitt von dem zweiten Abschnitt weg erstrecken.

6. Leistungssteuerungssystem nach Anspruch 1-5, weiter umfassend:
einen Eingangs-/Ausgangsverbinder (40), der mit der Schaltungsplatine (14) verbunden ist und konfiguriert ist, um die Ausgangsleistung von dem ersten Schalter (24) zu empfangen und die Ausgangsleistung der mindestens einen Last bereitzustellen.

7. Leistungssteuerungssystem nach Anspruch 1-6, wobei der erste Abschnitt (34) der ersten Verteilungsschiene mit der Sammelschiene durch ein erstes Befestigungselement verbunden ist, und der dritte Abschnitt (38) der ersten Verteilungsschiene mit der Schaltungsplatine durch ein zweites Befestigungselement verbunden ist.

8. Leistungssteuerungssystem nach Anspruch 1-7, wobei der erste Leistungsschalter (24) unter Verwendung eines dritten Befestigungselements mit dem zweiten Abschnitt (36) verbunden ist, und wobei der erste Leistungsschalter (24) mit der Schaltungsplatine (14) durch eine Lötstelle oder - verbindung verbunden ist.

## Revendications

1. Système de commande de puissance comprenant une carte de circuit imprimé (14) et une barre omnibus (16) connectée à la carte de circuit imprimé (14) et conçue pour recevoir une puissance d'entrée provenant d'une source de puissance externe, le système de commande de puissance étant **caractérisé par** :
une première barre de distribution (12a) connectée pour recevoir la puissance d'entrée provenant de la barre omnibus (16), dans lequel la première barre de distribution (12a) comprend :
une première section (34) pouvant être connectée à la barre omnibus (16) pour recevoir la puissance d'entrée ;
une deuxième section (36) conçue pour transporter la puissance d'entrée provenant de la première section (34) ;
une troisième section (38) pouvant être connectée à la carte de circuit imprimé (14) ;
un premier commutateur d'alimentation (24) connecté à la deuxième section (36) et conçu pour distribuer sélectivement la puissance d'entrée en tant que puissance de sortie à au moins une charge ;
un second commutateur d'alimentation conçu pour distribuer sélectivement la puissance d'entrée en tant que puissance de sortie à l'au moins une charge, dans lequel le premier commutateur d'alimentation (24) est connecté à un premier côté de la deuxième section (36) de la première barre de distribution, et dans lequel le second commutateur d'alimentation est connecté à un second côté opposé au premier côté de la deuxième section de la première barre de distribution, et dans lequel la deuxième section (36) est perpendiculaire à la carte de circuit imprimé (14) ; et
dans lequel la première section (34) et la troisième section (38) s'étendent à l'écart de la deuxième section.

2. Système de commande de puissance selon la revendication 1, dans lequel la première section (34) et la troisième section (38) de la première barre de distribution s'étendent le long d'un premier axe, et la deuxième section de la première barre de distribution s'étend le long d'un second axe, et dans lequel les premier et second axes sont perpendiculaires.

3. Système de commande de puissance selon la revendication 1 ou 2, dans lequel la première section (34) de la première barre de distribution se trouve dans un premier plan, la deuxième section (36) de la première barre de distribution se trouve dans un deuxième plan et la troisième section (38) de la première barre de distribution se trouve dans un troisième plan, et dans lequel les premier, deuxième et troisième plans sont orthogonaux.

4. Système de commande de puissance selon la revendication 1, 2 ou 3, comprenant en outré :
une zone de commande connectée à la carte de circuit imprimé (14) et conçue pour commander le premier commutateur d'alimentation pour distribuer sélectivement la puissance d'entrée en tant que puissance de sortie à l'au moins une charge.

5. Système de commande de puissance selon les revendications 1 à 4, comprenant en outré :
au moins une seconde barre de distribution connectée pour recevoir la puissance d'entrée provenant de la barre omnibus, dans lequel la seconde barre de distribution comprend :
une première section pouvant être connectée à la barre omnibus pour recevoir la puissance d'entrée ;
une deuxième section conçue pour transporter la puissance d'entrée provenant de la première section de la seconde barre de distribution ;
une troisième section pouvant être connectée à la carte de circuit imprimé ;
un premier commutateur d'alimentation connecté à la deuxième section de l'au moins une seconde barre de distribution et conçu pour distribuer sélectivement la puissance d'entrée en tant que puissance de sortie à l'au moins une charge ; et
dans lequel la première section et la troisième section s'étendent à l'écart de la deuxième section.

6. Système de commande de puissance selon les revendications 1 à 5, comprenant en outré :
un connecteur d'entrée/de sortie (40) connecté à la carte de circuit imprimé (14) et conçu pour recevoir la puissance de sortie provenant du premier commutateur (24) et fournir la puissance de sortie à l'au moins une charge.

7. Système de commande de puissance selon les revendications 1 à 6, dans lequel la première section (34) de la première barre de distribution est connectée à la barre omnibus par une première attache et la troisième section (38) de la première barre de distribution est connectée à la carte de circuit imprimé par une deuxième attache.

8. Système de commande de puissance selon les revendications 1 à 7, dans lequel le premier commutateur d'alimentation (24) est connecté à la deuxième section (36) en utilisant une troisième attache, et dans lequel le premier commutateur d'alimentation (24) est connecté à la carte de circuit imprimé (14) à travers un joint ou un raccord de brasure.
